# EUROPEAN PATENT SPECIFICATION

(11) **EP 2 851 691 B1**
(45) Date of publication and mention of the grant of the patent: **04.12.2019**
(21) Application number: 13791069.1
(22) Date of filing: 03.04.2013
(51) Int. Cl.: G01R 15/20, G01R 33/02

(54) **CURRENT SENSOR**
STROMSENSOR
CAPTEUR DE COURANT

(30) Priority: 16.05.2012 JP 2012112340
(43) Date of publication of application: 25.03.2015
(73) Proprietor: Alps Alpine Co., Ltd., Tokyo 145-8501 (JP)
(72) Inventor: TAMURA, Manabu, Tokyo 145-8501 (JP)
(74) Representative: Schmitt-Nilson Schraud Waibel Wohlfrom Patentanwälte Partnerschaft mbB
(86) International application number: PCT/JP2013/060227
(87) International publication number: WO 2013/172109

(56) References cited:
- WO-A1-2012/035906
- JP-A- 2001 066 327
- JP-A- 2006 071 457
- JP-A- 2010 266 290
- US-A1- 2009 121 704
- US-A1- 2010 207 603

## Description

### Technical Field

The present invention relates to current sensors that can measure a current flowing through a conductor in a non-contact manner, and specifically to a current sensor that measures a current by detecting a magnetic field generated by the current.

### Background Art

Current sensors that can measure a current in a non-contact manner on the basis of an induced magnetic field generated by the current to be measured have been put into practical use. Such a current sensor includes a magnetoelectric conversion device for detecting an induced magnetic field and measures a current on the basis of the strength of the magnetic field detected by the magnetoelectric conversion device. Examples of magnetoelectric conversion devices which have been used include a Hall element that converts the strength of a magnetic field into an electric signal using the Hall effect and a magnetoresistive sensor that utilizes a change in electric resistance due to a magnetic field.

A non-contact current sensor may be used to measure, for example, a current flowing through an inverter for driving a motor. Since currents with a plurality of phases flow through an inverter, to realize high current measurement accuracy in this application, it is necessary to appropriately remove the influence of an induced magnetic field generated by currents having unrelated phases. For such an objective, a current sensor has been proposed which has a configuration in which a plurality of current-path-forming conductors are arranged in a single plane and magnetic sensors are arranged symmetrically about the plane (refer to, for example, PTL 1).

### Citation List

### Patent Literature

PTL 1: Japanese Unexamined Patent Application Publication No. 2007-108069

WO 2012/035906 A1 discloses a current sensor equipped with: a pair of magnetic sensors which are arranged around a first electric wire through which the current being measured flows, and which output a reversed phase output signal by means of the induction field from the current flowing through the first electric wire, and which each have sensitivity in the direction orthogonal to the sensitive axis; and a calculation device which is connected to the pair of magnetic sensors, and which carries out a differential calculation on the output signals from the pair of magnetic sensors. The magnetic sensors are arranged such that the non-sensitive axes thereof face in the direction of the induction field from the current flowing through a second electric wire which is adjacent to the first electric wire.

### Summary of Invention

### Technical Problem

In the current sensor described above, since the magnetic sensors are arranged in such a manner as to be unlikely to be influenced by induced magnetic fields generated by currents with unrelated phases, a certain degree of current measurement accuracy is maintained. However, the magnetic sensors need to be arranged in such a manner as to be inclined against the current paths to realize sufficiently high current measurement accuracy and, hence, this configuration is not realistic from the viewpoints of mounting accuracy and manufacturing cost.

In view of the above situations, it is an object of the present invention to provide a current sensor with a simple structure in which the influence of an induced magnetic field generated by a current flowing through a neighboring conductor can be removed.

### Solution to Problem

A current sensor of the present invention is defined by the features of claim 1.

With this configuration, by using a simple configuration in which the first conductor, the second conductor, the first magnetoelectric conversion device, and the second magnetoelectric conversion device are located in the same plane, the output (change in output) of the first magnetoelectric conversion device and the output (change in output) of the second magnetoelectric conversion device can be made to have the same polarity and, hence, the influence of an induced magnetic field generated by a current flowing through the second conductor can be removed by a differential operation. In other words, it is possible to realize a current sensor with a simple structure which can remove the influence of an induced magnetic field generated by a current flowing through the second conductor neighboring the first conductor.

In the current sensor of the present invention, it is preferable that the first conductor and the second conductor have plate shapes whose width directions are perpendicular to the plane, and center positions of the first conductor and the second conductor in the width direction be located in the plane. With this configuration, the direction of the induced magnetic field generated by the current flowing through the second conductor becomes unlikely to change near the center position of the first conductor. Hence, even when the positions at which the first magnetoelectric conversion device and the second magnetoelectric conversion device are arranged vary to some extent, the directions of the applied induced magnetic field at the first magnetoelectric conversion device and the second magnetoelectric conversion device become approximately the same and, hence, the influence of the induced magnetic field generated by the current flowing through the second conductor can be more appropriately removed.

It is preferable that the current sensor of the present invention include a pair of magnetic shields that crosses the plane and are arranged in such a manner that the first conductor, the first magnetoelectric conversion device, and the second magnetoelectric conversion device are sandwiched therebetween. With this configuration, the influence of the induced magnetic field generated by the current flowing through the second conductor can be further reduced by the pair of magnetic shields, whereby higher current measurement accuracy is realized.

In the current sensor of the present invention, it is preferable that the first magnetoelectric conversion device and the second magnetoelectric conversion device be arranged in such a manner that sensitivity axis directions thereof are perpendicular to the plane.

In the current sensor of the present invention each of the first conductor and the second conductor include a thin-plate portion and thick-plate portions arranged on two sides of the thin-plate portion, and the first magnetoelectric conversion device and the second magnetoelectric conversion device be arranged in such a manner that the thin-plate portion of the first conductor is sandwiched therebetween. With this configuration, the electric resistance of the first conductor is reduced by the thick-plate portions and, hence, generation of heat due to a flowing current to be measured can be suppressed. As a result, higher current measurement accuracy is realized.

### Advantageous Effects of Invention

According to the present invention, a current sensor with a simple structure that can remove the influence of an induced magnetic field generated by a current flowing through a neighboring conductor can be provided.

### Brief Description of Drawings

[Fig. 1] Fig. 1 is a schematic diagram illustrating an example configuration of a current sensor.
[Fig. 2] Fig. 2 is a block diagram illustrating the circuit configuration of the current sensor of Fig. 1.
[Fig. 3] Fig. 3 is a schematic diagram illustrating an example configuration of a circuit sensor as a comparative example.
[Fig. 4] Fig. 4 is a schematic diagram illustrating an example configuration of another current sensor.
[Fig. 5] Fig. 5 is a schematic diagram illustrating an example configuration of yet another current sensor.
[Fig. 6] Fig. 6 is a schematic diagram illustrating an example configuration of a current sensor according to an embodiment of the invention.
[Fig. 7] Fig. 7 is a diagram illustrating the influence of a neighboring current in each configuration.

### Description of Embodiments

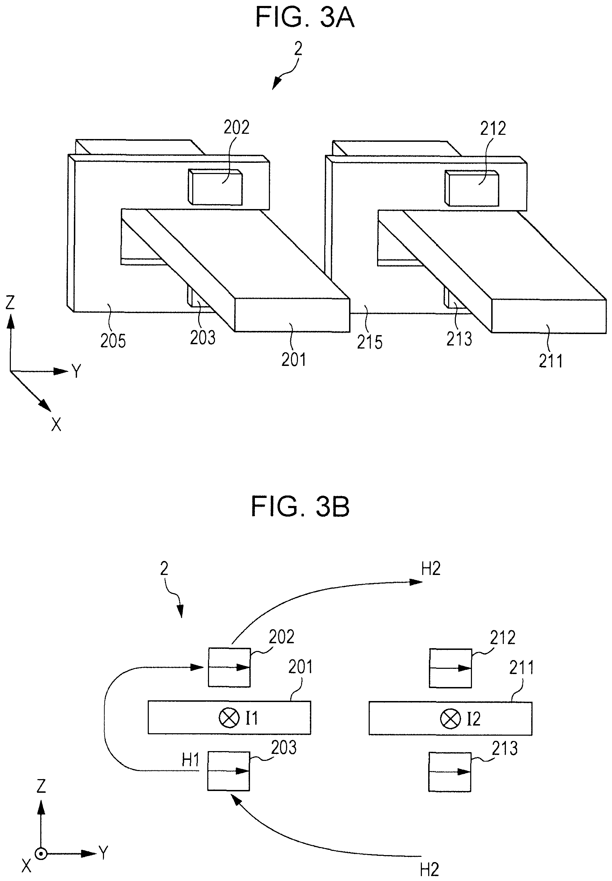

Referring to Fig. 3, an example configuration of a representative current sensor will be described. Fig. 3 is a schematic diagram illustrating an example configuration of a current sensor 2 in which a plurality of conductors forming current paths are arranged close to each other. Fig. 3A is a perspective view of a schematic configuration of the current sensor 2, and Fig. 3B is a schematic diagram illustrating the positional relationship between conductors 201 and 211 and magnetoelectric conversion devices 202, 203, 212, and 213 in the current sensor 2.

Referring to Fig. 3A, the current sensor 2 includes the conductors 201 and 211 which form current paths and the magnetoelectric conversion devices 202 and 203 which are arranged with the conductor 201 therebetween. The magnetoelectric conversion devices 202 and 203 are mounted on a substantially U-shaped circuit substrate 205 which is arranged in a portion surroudning the conductor 201. On the circuit substrate 205, a computing circuit (not illustrated) connected to the magnetoelectric conversion devices 202 and 203 is provided, and the outputs of the magnetoelectric conversion devices 202 and 203 are subjected to a differential operation in the computing circuit. Note that the magnetoelectric conversion devices 212 and 213, a circuit substrate 215, and a computing circuit (not illustrated) having similar configurations are arranged also on the conductor 211 side.

Referring to Fig. 3B, the current sensor 2 detects an induced magnetic field H1 generated by a current I1 to be measured flowing through the conductor 201 using the magnetoelectric conversion devices 202 and 203 and outputs an electric signal (voltage, for example) corresponding to the current I1 to be measured. The magnetoelectric conversion devices 202 and 203 are arranged in such a manner that their sensitivity axes are oriented in the same direction, and generates a pair of outputs with opposite polarities upon receipt of the induced magnetic field H1. The outputs of the magnetoelectric conversion devices 202 and 203 are subjected to a differential operation in the computing circuit connected to the magnetoelectric conversion devices 202 and 203, and the operation result is output to a subsequent stage as the output of the current sensor 2.

In the current sensor 2, when a current 12 flows through the conductor 211, an induced magnetic field H2 caused by the current 12 is generated at a position where the magnetoelectric conversion devices 202 and 203 are arranged. The magnetoelectric conversion devices 202 and 203, upon receipt of the induced magnetic field H2, generates a pair of outputs (changes in outputs) with opposite polarities in accordance with a component of the induced magnetic field H2 in the sensitivity axis direction. Here, for example, when the output is a voltage, the polarity of the output refers to whether the output voltage is positive or negative, and a pair of outputs (changes in outputs) with opposite polarities refer to a pair of positive and negative output voltages having the same magnitude.

The outputs, with opposite polarities, of the magnetoelectric conversion devices 202 and 203 described above cannot be cancelled out by the differential operation of the computing circuit and, hence, the sensor output of the current sensor 2 varies due to the influence of the induced magnetic field H2. In other words, in the current sensor 2, current measurement accuracy is decreased due to the influence of the current 12 flowing through the neighboring conductor 211.

The reason why the current measurement accuracy is reduced in the current sensor 2 is because outputs (changes in outputs) with opposite polarities that cannot be cancelled out by a differential operation are generated in the magnetoelectric conversion devices 202 and 203. In other words, it is thought that this problem will be solved if the outputs (changes in outputs) of the magnetoelectric conversion devices 202 and 203 caused by the influence of the induced magnetic field H2 can be made to have the same polarity.

The inventor of the present invention has noted this point, and thought that the outputs (change in output) of the pair of magnetoelectric conversion devices can be made to have the same polarity when the arrangement of the components of a current sensor is well-designed. It was found that the outputs (changes in outputs) of a pair of magnetoelectric conversion devices can be made to have the same polarity by arranging the pair of magnetoelectric conversion devices at locations that allow the induced magnetic fields generated by currents flowing through neighboring current paths to have the same direction. The present invention has been completed by utilizing this finding.

In other words, the outline of the present invention is that a second conductor that is adjacent to a first conductor which forms the current path of a current to be measured and first and second magnetoelectric conversion devices that are arranged with the first conductor therebetween are arranged along the same plane. With this simple configuration, the directions of an induced magnetic field generated by a current flowing through the second conductor can be made to be approximately the same at the first magnetoelectric conversion device and the second magnetoelectric conversion device, and the outputs (changes in outputs) of the first magnetoelectric conversion device and the second magnetoelectric conversion device can be made to have the same polarity. As a result, the influence of an induced magnetic field due to a current flowing through the second conductor can be removed by a differential operation.

Here, the "same plane" refers to a virtual plane indicating the locations where the second conductor, the first magnetoelectric conversion device, and the second magnetoelectric conversion device are arranged, and "being arranged along the same plane" refers to being arranged near the virtual plane such that the influence of the induced magnetic field generated by a current flowing through the second conductor forming the neighboring current path can be reduced. For example, even when the directions of an induced magnetic field generated by a current flowing through the second conductor differ between a position where the first magnetoelectric conversion device is arranged and a position where the second magnetoelectric conversion device is arranged, if the difference is small (for example within 10°), the influence of the induced magnetic field generated by the current flowing through the second conductor can be reduced to a level (about 1%) that causes practically no problems. Hence, also an arrangement in which the difference between the directions of an induced magnetic field which is generated by a current flowing through the second conductor is within 10° will be included in the case of "being arranged along the same plane". Hereinafter, embodiments of the present invention will be described in detail with reference to the attached drawings.

### (First embodiment)

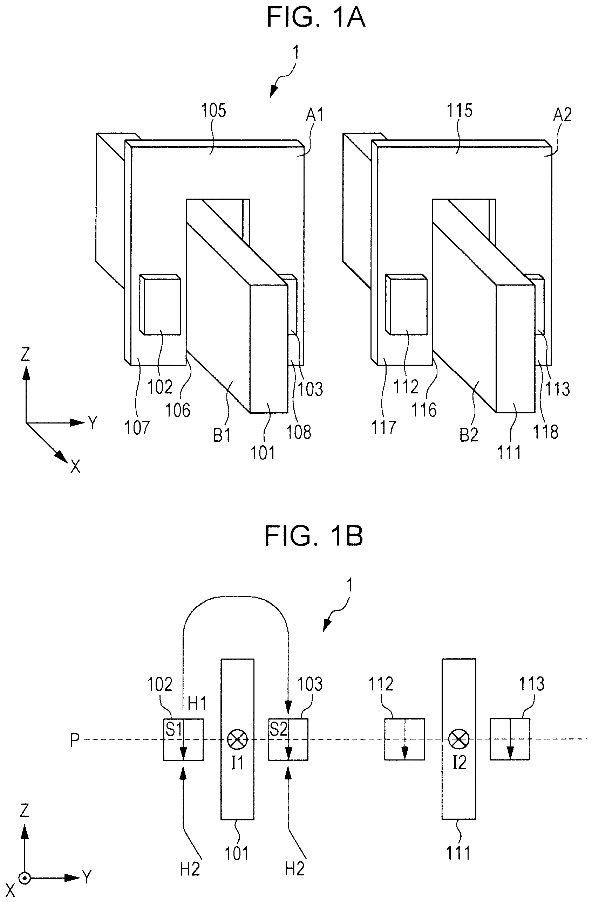

In the present embodiment, a first form of a current sensor will be described. Fig. 1 is a schematic diagram illustrating an example configuration of a current sensor 1 according to the present embodiment. Fig. 1A is a perspective view illustrating a schematic configuration of the current sensor 1, and Fig. 1B is a schematic diagram illustrating the positional relationship between conductors 101 and 111 and magnetoelectric conversion devices 102, 103, 112, and 113, in the current sensor 1.

Referring to Fig. 1A, the current sensor 1 includes the conductor (first conductor) 101 and the conductor (second conductor) 111 which form current paths. The conductors 101 and 111 both extend in a first direction (X-axis direction) and are shaped like flat plates parallel to each other. The conductors 101 and 111 have a predetermined thickness in a second direction (Y-axis direction) perpendicular to the first direction and have a predetermined width in a third direction (Z-axis direction) perpendicular to the first and second directions.

A circuit substrate 105 which is shaped like a substantially U-shaped flat plate is arranged near the conductor 101. The circuit substrate 105 has a recess-shaped cut-out portion 106 and is provided with a pair of arm portions 107 and 108 extending in the third direction on the two sides of the cut-out portion 106. The conductor 101 is positioned within the cut-out portion 106 of the circuit substrate 105. The circuit substrate 105 is arranged in such a manner that a surface A1, which is a main surface, is perpendicular to the first direction (i.e., the direction of a current path) in which the conductor 101 extends.

The magnetoelectric conversion device 102 (first magnetoelectric conversion device) and the magnetoelectric conversion device 103 (second magnetoelectric conversion device) are respectively arranged on the surface A1 side of the pair of arm portions 107 and 108. More specifically, the magnetoelectric conversion device 102 is arranged on one side of a main surface B1 (surface parallel to the XZ-plane) of the conductor 101 and the magnetoelectric conversion device 103 is arranged on the other side of the main surface B1.

Referring to Fig. 1B, the magnetoelectric conversion devices 102 and 103 are arranged in such a manner that respective sensitivity axes S1 and S2 have the same direction in a plane which is parallel to the surface A1 of the circuit substrate 105. Further, the magnetoelectric conversion devices 102 and 103 are arranged in such a manner that the respective sensitivity axes S1 and S2 are oriented in the third direction approximately parallel to the main surface B1 of the conductor 101. Hence, when the current I1 to be measured flows through the conductor 101, the induced magnetic field H1 is applied to the magnetoelectric conversion devices 102 and 103 in directions opposite to each other with respect to the sensitivity axes of the magnetoelectric conversion devices 102 and 103.

The magnetoelectric conversion devices 102 and 103 are arranged along a straight line connecting the center positions that respectively divide the widths (lengths in the third direction) of the conductors 101 and 111 into halves. In other words, as illustrated in Fig. 1B, the magnetoelectric conversion devices 102 and 103 are arranged along a virtual plane (plane) P that includes the center positions of the conductors 101 and 111 in the width direction. The virtual plane P is a plane parallel to the XY plane and is perpendicular to the surface A1 of the circuit substrate 105. Hence, the sensitivity axis directions of the magnetoelectric conversion devices 102 and 103 are perpendicular to the virtual plane P.

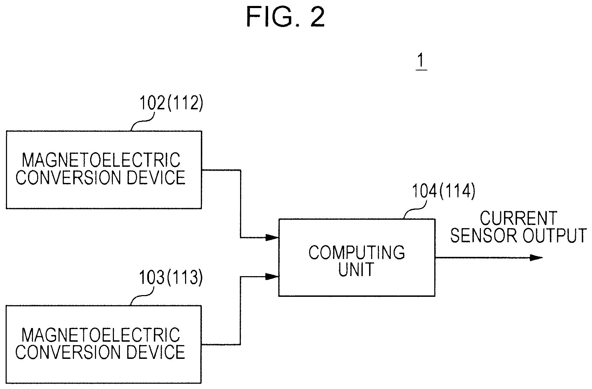

Fig. 2 is a block diagram illustrating the circuit configuration of the current sensor 1. Referring to Fig. 2, a computing circuit 104 is connected to the output stages of the magnetoelectric conversion devices 102 and 103. The computing circuit 104, which is mounted on a circuit substrate 105, performs a differential operation on the outputs of the magnetoelectric conversion devices 102 and 103 and outputs a computation result. The influence of the same-polarity outputs (changes in outputs) supplied from the magnetoelectric conversion devices 102 and 103 is weakened by the differential operation of the computing circuit 104. In other words, the influence of a magnetic field (for example, earth magnetism) applied to the magnetoelectric conversion devices 102 and 103 in identical directions with respect to the respective sensitivity axes is weakened by the differential operation, whereby the current measurement accuracy is maintained at a high level.

Note that the magnetoelectric conversion devices 112 and 113, a circuit substrate 115, and a computing circuit 114, having similar configurations, are arranged also on the conductor 111 side. In other words, the circuit substrate 115 having a recess-shaped cut-out portion 116 is arranged near the conductor 111, and the magnetoelectric conversion devices 112 and 113 are respectively arranged on the surface A2 side of a pair of arm portions 117 and 118 of the circuit substrate 115 with the conductor 111 therebetween. The magnetoelectric conversion device 112 is arranged on one side of a main surface B2 of the conductor 111 and the magnetoelectric conversion device 113 is arranged on the other side of the main surface B2. Further, the computing circuit 114 is connected to the output stages of the magnetoelectric conversion devices 112 and 113. However, the current sensor 1 need not include the conductor-lll-side configuration.

When the current 12 illustrated in Fig. 1B flows through the conductor 111 configured as described above, the induced magnetic field H2 caused by the current 12 is generated at the positions where the magnetoelectric conversion devices 102 and 103 are arranged. Since the directions of the induced magnetic field H2 at the positions where the magnetoelectric conversion devices 102 and 103 are arranged are approximately the same, the corresponding influences of the induced magnetic field H2 are cancelled out by the differential operation of the computing circuit 104.

In this manner, since the current sensor 1 has a configuration in which the conductor 111 and the magnetoelectric conversion devices 102 and 103 (the conductor 101 may be included) are arranged along the same virtual plane P, the influence of the induced magnetic field H2 generated by the current 12 flowing through the conductor 111 can be removed from the sensor output. In this case, since the magnetoelectric conversion devices need not be arranged in such a manner as to be slanted with respect to the conductors 101 and 111, high current measurement accuracy is realized using a simple configuration.

Further, since each of the conductors 101 and 111 is shaped like a flat plate whose width direction is perpendicular to the virtual plane P, and is arranged in such a manner that the center position in the width direction thereof is along the virtual plane P, the direction of the induced magnetic field H2 generated by the current 12 flowing through the conductor 111 becomes unlikely to change near the center position of the conductor 101. As a result, even when the positions at which the magnetoelectric conversion devices 102 and 103 are arranged are varied to some extent, the directions of the applied induced magnetic field H2 at the magnetoelectric conversion devices 102 and 103 become approximately the same and, hence, the influence of the induced magnetic field H2 can be appropriately removed.

In this manner, the positions at which the conductor 111, the magnetoelectric conversion devices 102 and 103 (the conductor 101 may be included) in the current sensor 1 are arranged need not be strictly along the virtual plane P. For example, even when the directions of an induced magnetic field generated by a current flowing through the conductor 111 are slightly different in accordance with the positions at which the magnetoelectric conversion devices 102 and 103 are arranged, the influence of the induced magnetic field generated by the current flowing through the conductor 111 can be reduced to such an extent that practically no problems are generated, as long as the difference between the directions is small (for example, within 10°). Hence, "being arranged along the same virtual plane P" includes the case in which the difference between the directions of the induced magnetic field generated by a current flowing through the conductor 111 is within 10°.

### (Second embodiment)

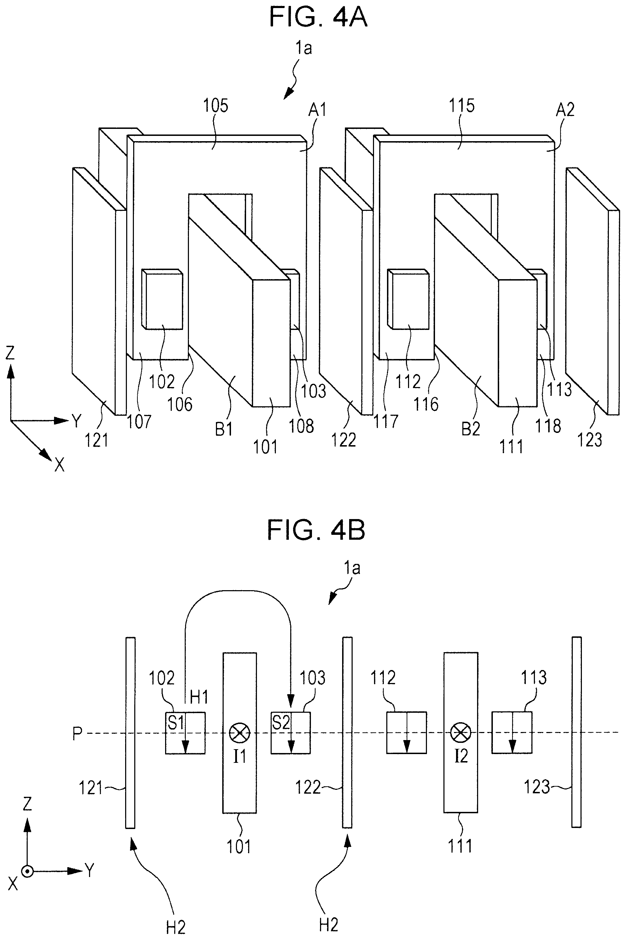

In the present embodiment, a second embodiment of a current sensor will be described. Fig. 4 is a schematic diagram illustrating an example configuration of a current sensor 1a according to the present embodiment. Fig. 4A is a schematic perspective view of the configuration of the current sensor 1a, and Fig. 4B is a schematic diagram illustrating the positional relationship among conductors 101 and 111, magnetoelectric conversion devices 102 and 103, 112, and 113, and magnetic shields (magnetic yokes) 121, 122, and 123, in the current sensor la. Note that many of the components of the current sensor 1a are common to those of the current sensor 1 according to the first embodiment. Hence components that are common to those of the current sensor 1 are denoted by the same reference symbols and detailed description thereof is omitted.

Referring to Fig. 4A, the current sensor 1a of the present embodiment includes the magnetic shields (magnetic yokes) 121 and 122 shaped like thin plates made of a high-permeability material provided respectively at a position outside the magnetoelectric conversion device 102 (opposite the conductor 101) and at a position outside the magnetoelectric conversion device 103 (opposite the conductor 101). In other words, the magnetic shields 121 and 122 are arranged with the magnetoelectric conversion devices 102 and 103 and the conductor 101 therebetween. Further, as illustrated in Fig. 4B, the magnetic shields 121 and 122 are arranged in such a manner as to cross the virtual plane P.

When the magnetic shields 121 and 122 made of a high-permeability material described above are arranged, magnetic flux around the magnetic shields 121 and 122 concentrates at the magnetic shields 121 and 122. Hence, as illustrated in Fig. 4B, the influence of an induced magnetic field H2 generated by a current 12 flowing through the conductor 111 on the magnetoelectric conversion device 102 and that on the magnetoelectric conversion device 103 are balanced and can be more appropriately cancelled out.

Note that the magnetic shield 123 having a similar configuration is arranged also on the conductor 111 side. In other words, the magnetic shield 123 is provided at a position outside (opposite the conductor 111) the magnetoelectric conversion device 113, and the magnetoelectric conversion devices 112 and 113 and the conductor 111 are sandwiched between the magnetic shields 122 and 123. Further, the magnetic shield 123 is arranged in such a manner as to cross the virtual plane P. However, the current sensor 1a need not include the configuration on the conductor 111 side.

In this manner, since the current sensor 1a can further reduce the influence of the induced magnetic field H2 generated by the current 12 flowing through the conductor 111 using a pair of the magnetic shields 121 and 122, higher current measurement accuracy can be realized. The configuration illustrated in the present embodiment can be appropriately implemented in combination with the configurations illustrated in other embodiments.

### (Third embodiment)

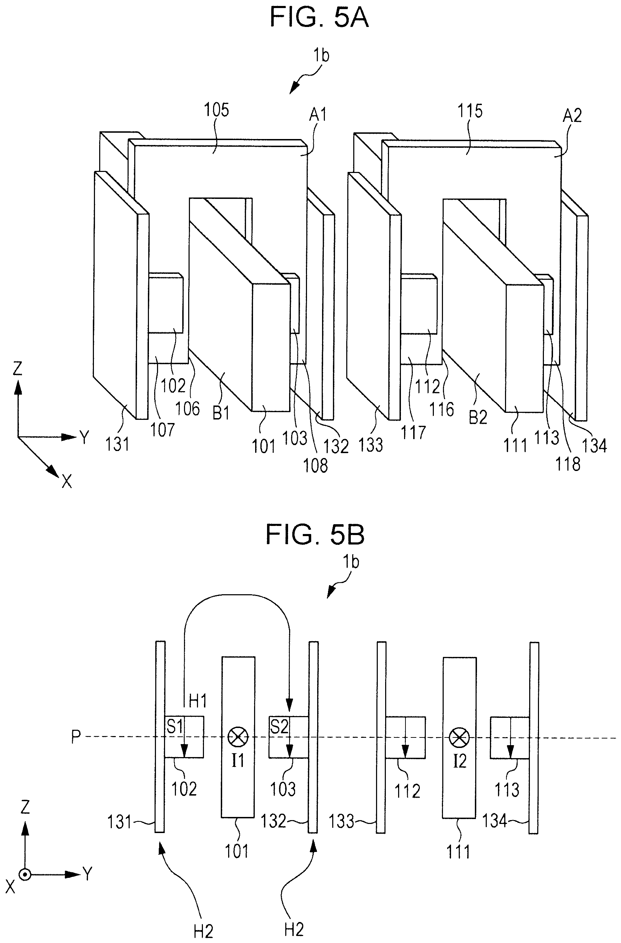

In the present embodiment, a third embodiment of a current sensor will be described. Fig. 5 is a schematic diagram illustrating an example configuration of a current sensor 1b according to the present embodiment. Fig. 5A is a schematic perspective view of the configuration of the current sensor 1b, and Fig. 5B is a schematic diagram illustrating the positional relationship among conductors 101 and 111, magnetoelectric conversion devices 102 and 103, 112, and 113, and magnetic shields 131, 132, 133, and 134, in the current sensor 1b. Note that many of the components of the current sensor 1b of the present embodiment are common to those of the current sensor 1 according to the first embodiment. Hence, components common to those in the current sensor 1 are denoted by the same reference symbols and detailed description thereof is omitted.

Referring to Fig. 5A, the current sensor 1b of the present embodiment also includes the magnetic shields (magnetic yokes) 131 and 132 shaped like thin plates made of a high-permeability material provided respectively at a position outside the magnetoelectric conversion device 102 (opposite the conductor 101) and at a position outside the magnetoelectric conversion device 103 (opposite the conductor 101). In other words, the magnetic shields 131 and 132 are arranged with the magnetoelectric conversion devices 102 and 103 and the conductor 101 therebetween. Further, as illustrated in Fig. 5B, the magnetic shields 131 and 132 are arranged in such a manner as to cross the virtual plane P.

When the magnetic shields 131 and 132 made of a high-permeability material described above are arranged, magnetic flux around the magnetic shields 131 and 132 concentrates at the magnetic shields 131 and 132. Hence, as illustrated in Fig. 5B, the influence of an induced magnetic field H2 generated by a current 12 flowing through the conductor 111 on the magnetoelectric conversion device 102 and that on the magnetoelectric conversion device 103 are balanced and can be more appropriately cancelled out.

Note that the magnetic shields 133 and 134 having similar configurations are arranged also on the conductor 111 side. In other words, the magnetic shield 133 is provided at a position outside the magnetoelectric conversion device 112 (opposite the conductor 111), and the magnetic shield 134 is provided at a position outside the magnetoelectric conversion device 113 (opposite the conductor 111). The magnetoelectric conversion devices 112 and 113 and the conductor 111 are sandwiched between the magnetic shields 133 and 134. Further, the magnetic shields 133 and 134 are arranged in such a manner as to cross the virtual plane P. However, the current sensor 1b need not include the configuration on the conductor 111 side.

In this manner, since the current sensor 1b can further reduce the influence of the induced magnetic field H2 generated by the current 12 flowing through the conductor 111 using a pair of the magnetic shields 131 and 132, higher current measurement accuracy can be realized. Further, since the magnetic shields 131, 132, 133, and 134 are arranged in such a manner as to correspond to the magnetoelectric conversion devices 102, 103, 112, and 113 in the current sensor 1b, the magnetic shields 131, 132, 133, and 134 can be arranged sufficiently close to the magnetoelectric conversion devices 102, 103, 112, and 113. Hence, higher current measurement accuracy can be realized compared with the current sensor 1a of the second embodiment. The configuration illustrated in the present embodiment can be appropriately implemented in combination with the configurations illustrated in other embodiments.

### (Fourth embodiment)

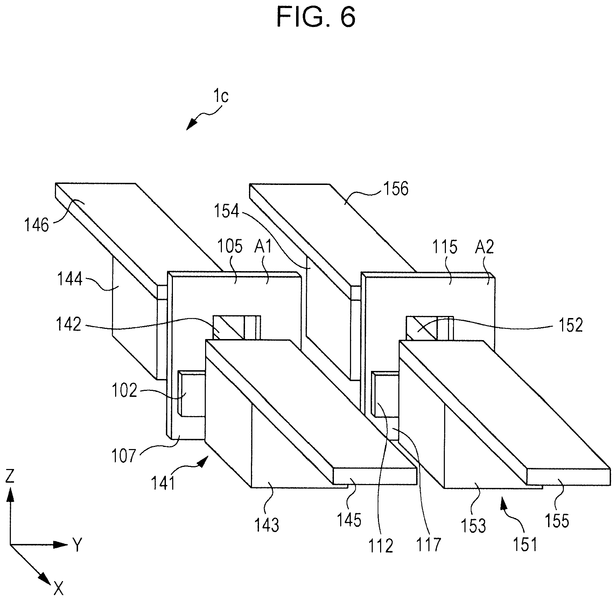

In the present embodiment, a fourth embodiment of a current sensor will be described. Fig. 6 is schematic diagram illustrating an example configuration of a current sensor 1c according to the present embodiment. Note that many of the components of the current sensor 1c of the present embodiment are common to those of the current sensor 1 according to the first embodiment. Hence, components common to those in the current sensor 1 are denoted by the same reference symbols and detailed description thereof is omitted.

Referring to Fig. 6, the current sensor 1c of the present embodiment includes a conductor (first conductor) 141 and a conductor (second conductor) 151 having shapes different from those of the current sensor 1 according to the first embodiment. The conductors 141 and 151 extend in the first direction (X-axis direction). The conductor 141 is formed of thick-plate portions 143 and 144 and a thin-plate portion 142 located therebetween. The conductor 151 is formed of thick-plate portions 153 and 154 and a thin-plate portion 152 located therebetween.

The thickness of the thin-plate portions 142 and 152 in the second direction is smaller than that of the thick-plate portions 143, 144, 153, and 154 in the second direction. On the other hand, the width of the thin-plate portions 142 and 152 in the third direction is approximately the same as that of the thick-plate portions 143, 144, 153, and 154 in the third direction. The thin-plate portions 142 and 152 are positioned within the cut-out portion 106 of the circuit substrate 105, and the thin-plate portion 142 of the conductor 141 is sandwiched between the magnetoelectric conversion devices 102 and 103 (the magnetoelectric conversion device 103 is not illustrated in Fig. 6).

Conductors 145, 146, 155, and 156 extending in the first direction (X-axis direction) are respectively connected to the thick-plate portions 143, 144, 153, and 154. Each of the conductors 145, 146, 155, and 156 is shaped like a flat plate parallel to the XY-plate. Note that the current sensor 1c need not include the conductors 145, 146, 155, and 156.

As described above, the current sensor 1c of the present embodiment includes the conductor 141 provided with the thick-plate portions 143 and 144 on the two sides of the thin-plate portion 142 at which the magnetoelectric conversion devices 102 and 103 are arranged. Hence when the circuit substrate 105 (and a casing housing the circuit substrate 105) is arranged in such a manner as to be sandwiched between the thick-plate portions 143 and 144, the magnetoelectric conversion devices 102 and 103 can be more appropriately positioned with respect to the conductor 141. Further, the thick-plate portions 143 and 144 reduce the electric resistance of the conductor 141, thereby reducing heat generation caused by the flowing current I1 to be measured. As a result, higher current measurement accuracy is realized. Further, by making the thick-plate portions 143 and 144 function as terminal bases, the extension conductors 145 and 146 can be easily attached. The configuration illustrated in the present embodiment can be appropriately implemented in combination with the configurations illustrated in other embodiments.

### (Examples)

Examples of a current sensor prepared for confirming the effectiveness of the current sensors illustrated in the above embodiments will be described. However, the configuration of the present invention is not limited to the description of the examples.

The measurement errors caused by the influence of a neighboring current were computed regarding current sensors having similar configurations to the current sensor 1 (refer to Fig. 1) of the first embodiment and the current sensor 1b (refer to Fig. 5) of the third embodiment (first and second examples). Further, for comparison, a measurement error caused by the influence of a neighboring current was computed regarding the current sensor 2 illustrated in Fig. 3 (comparative example). In the first and second examples and the comparative example, conductors whose cross-sectional shape (shape of a cross section parallel to the YZ plane) is a rectangle (10 mm × 2 mm) were used as conductors (corresponding to the conductors 101 and 202) through which a current to be measured flows and conductors (corresponding to the conductors 111 and 211) through which a neighboring current flows. The distance between the center of the conductor through which a current to be measured flows and the center of the conductor through which a neighboring current flows was made to be 15 mm.

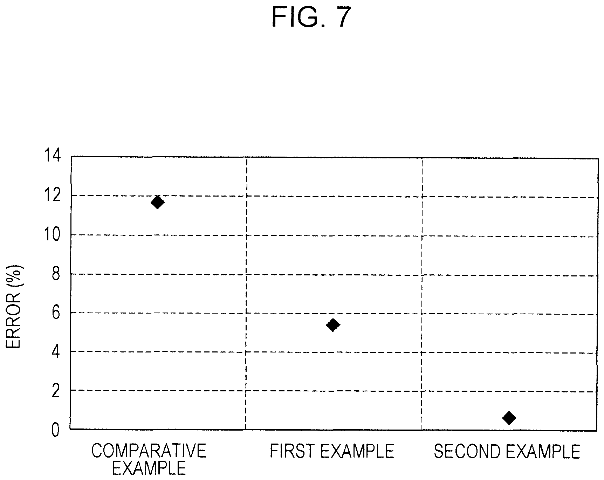

Fig. 7 is a diagram illustrating the influence of a neighboring current in each configuration. In Fig. 7, the vertical axis is a measurement error caused by a neighboring current, represented as a percentage of the magnitude of the neighboring current. As can be seen from Fig. 7, for example, when the neighboring current is 100 A, an error of 12 A is generated in the comparative example. On the other hand, the error is about 5 A in the first example, and the error is about 1 A or less in the second example. In other words, the influence of a neighboring current is suppressed to half that of the comparative example or less. In the second example, the influence of a neighboring current is suppressed to a very small level. As described above, the current sensors illustrated in the above embodiments can suppress the influence of a neighboring current.

Note that the present invention is not limited to the description of the above embodiments and examples, and can be implemented with various modifications. For example, although the above-described embodiments employ the configuration in which magnetoelectric conversion devices are arranged on a substantially U-shaped circuit substrate, the shape of the circuit substrate and the like is not specifically restricted as long as the magnetoelectric conversion devices are appropriately arranged with respect to a conductor through which a current flows. Further, in the above-described embodiments, although example cases have been illustrated in which another different conductor is located near a conductor through which a current to be measured flows, a plurality of conductors may be arranged close to the conductor through which the current to be measured flows. The connection relationships, positions, sizes, and ranges of the components in the above-described embodiments can be changed as appropriate in implementation. Not limited to these, the present invention can be appropriately changed in implementation.

### Industrial Applicability

The current sensor of the present invention is useful for measurement of a current which flows through an inverter for driving a motor, for example.

## Claims

1. A current sensor (1) comprising:
a first conductor (141) and a second conductor (151) arranged in such a manner as to form current paths parallel to each other;
a circuit substrate (105, 115) arranged in such a manner that a surface of the circuit substrate (105, 115) is perpendicular to the current paths; and
a first magnetoelectric conversion device (102, 112) and a second magnetoelectric conversion device (103, 113) arranged on the surface of the circuit substrate (105, 115) in such a manner that the first conductor (101) is sandwiched therebetween,
wherein the first conductor (141), the second conductor (151), the first magnetoelectric conversion device (102, 112), and the second magnetoelectric conversion device (103, 113) are all located in a same plane (P) perpendicular to the surface of the circuit substrate (105, 115);
wherein each of the first conductor (141) and the second conductor (151) includes a thin-plate portion (142, 152) and thick-plate portions (143, 144, 153, 154) arranged on two sides of the thin-plate portion (142, 152), and
wherein the first magnetoelectric conversion device (102, 112) and the second magnetoelectric conversion device (103, 113) are arranged in such a manner that the thin-plate (142) portion of the first conductor (101) is sandwiched therebetween..

2. The current sensor (1) according to Claim 1, wherein the first conductor (141) and the second conductor (151) have plate shapes whose width directions are perpendicular to the plane (P), and center positions of the first conductor (141) and the second conductor (151) in the width direction are located in the plane (P).

3. The current sensor (1) according to Claim 1 or Claim 2, further comprising:
a pair of magnetic shields (121, 122, 123) that crosses the plane (P) and are arranged in such a manner that the first conductor (141), the first magnetoelectric conversion device (102, 112), and the second magnetoelectric conversion device (103, 113) are sandwiched therebetween.

4. The current sensor (1) according to any one of Claim 1 to Claim 3, wherein the first magnetoelectric conversion device (102, 112) and the second magnetoelectric conversion device (103, 113) are arranged in such a manner that sensitivity axis directions thereof are perpendicular to the plane (P).

5. The current sensor (1) according to any one of Claim 1 to Claim 4, wherein the conductors (141, 151) extend in a first direction; wherein the thickness of the thin-plate portions (142, 152) in a second direction, which is oriented perpendicularly to the first direction, is smaller than that of the thick-plate portions (143, 144, 153, 154) in said second direction; wherein the width of the thin-plate portions (142 , 152) in a third direction, which is oriented perpendicularly to the first and second directions, is the same as that of the thick-plate portions (143, 144. 153, 154) in said third direction; wherein conductors (145, 146, 155, 156) are respectively connected to the thick-plate portions (143, 144, 153, 154) ; and wherein each of the conductors (145, 146, 155, 156) is shaped like a flat plate parallel to the first and third directions.

## Patentansprüche

1. Stromsensor (1), aufweisend:
einen ersten Leiter (141) und einen zweiten Leiter (151), die derart angeordnet sind, dass sie parallel zueinander verlaufende Strompfade bilden;
ein Schaltungssubstrat (105, 115), das derart angeordnet ist, dass eine Oberfläche des Schaltungssubstrats (105, 115) senkrecht zu den Strompfaden ist; und
eine erste magnetoelektrische Wandlervorrichtung (102, 112) und eine zweite magnetoelektrische Wandlervorrichtung (103, 113), die auf der Oberfläche des Schaltungssubstrats (105, 115) derart angeordnet sind, dass der erste Leiter (101) sandwichartig dazwischen angeordnet ist,
wobei der erste Leiter (141), der zweite Leiter (151), die erste magnetoelektrische Wandlervorrichtung (102, 112) und die zweite magnetoelektrische Wandlervorrichtung (103, 113) sich alle in einer gleichen Ebene (P) befinden, die senkrecht zu der Oberfläche des Schaltungssubstrats (105, 115) ist;
wobei der erste Leiter (141) und der zweite Leiter (151) jeweils einen dünnen Plattenbereich (142, 152) und dicke Plattenbereiche (143, 144, 153, 154) aufweisen, die beidseits von dem dünnen Plattenbereich (142, 152) angeordnet sind, und
wobei die erste magnetoelektrische Wandlervorrichtung (102, 112) und die zweite magnetoelektrische Wandlervorrichtung (103, 113) derart angeordnet sind, dass der dünne Plattenbereich (142) des ersten Leiters (101) sandwichartig dazwischen angeordnet ist.

2. Stromsensor (1) nach Anspruch 1,
wobei der erste Leiter (141) und der zweite Leiter (151) Plattenformen aufweisen, deren Breitenrichtungen senkrecht zu der Ebene (P) sind, und wobei sich in der Breitenrichtung zentrale Positionen des ersten Leiters (141) und des zweiten Leiters (151) in der Ebene (P) befinden.

3. Stromsensor (1) nach Anspruch 1 oder 2,
weiterhin aufweisend:
ein Paar magnetischer Abschirmungen (121, 122, 123) die die Ebene (P) kreuzen und derart angeordnet sind, dass der erste Leiter (141), die erste magnetoelektrische Wandlervorrichtung (102, 112) und die zweite magnetoelektrische Wandlervorrichtung (103, 113) sandwichartig dazwischen angeordnet sind.

4. Stromsensor (1) nach einem der Ansprüche 1 bis 3,
wobei die erste magnetoelektrische Wandlervorrichtung (102, 112) und die zweite magnetoelektrische Wandlervorrichtung (103, 113) derart angeordnet sind, dass ihre Empfindlichkeitsachsenrichtungen senkrecht zu der Ebene (P) angeordnet sind.

5. Stromsensor (1) nach einem der Ansprüche 1 bis 4,
wobei sich die Leiter (141, 151) in einer ersten Richtung erstrecken; wobei die Dicke der dünnen Plattenbereiche (142, 152) in einer zweiten Richtung, die senkrecht zu der ersten Richtung orientiert ist, kleiner ist als die Dicke der dicken Plattenbereiche (143, 144, 153, 154) in der zweiten Richtung;
wobei die Breite der dünnen Plattenbereiche (142, 152) in einer dritten Richtung, die senkrecht zu der ersten und der zweiten Richtung orientiert ist, die gleiche ist wie die Breite der dicken Plattenbereiche (143, 144, 153, 154) in der dritten Richtung;
wobei Leiter (145, 146, 155, 156) jeweils mit den dicken Plattenbereichen (143, 144, 153, 154) verbunden sind; und
wobei die Leiter (145, 146, 155, 156) jeweils nach Art einer ebenen Platte ausgebildet sind, die zu der ersten und der dritten Richtung parallel ist.

## Revendications

1. Détecteur de courant (1) comprenant :
un premier conducteur (141) et un second conducteur (151) disposés d'une manière telle qu'ils forment des chemins de courant parallèles l'un à l'autre ;
un substrat de circuit (105, 115) conçu d'une manière telle qu'une surface du substrat de circuit (105, 115) est perpendiculaire aux chemins de courant ; et
un premier dispositif de conversion magnétoélectrique (102, 112) et un second dispositif de conversion magnétoélectrique (103, 113) disposés sur la surface du substrat de circuit (105, 115) d'une manière telle que le premier conducteur (101) est intercalé entre eux ;
dans lequel le premier conducteur (141), le second conducteur (151), le premier dispositif de conversion magnétoélectrique (102, 112) et le second dispositif de conversion magnétoélectrique (103, 113) sont tous situés dans un même plan (P) perpendiculaire à la surface du substrat de circuit (105, 115) ;
dans lequel chaque conducteur parmi le premier conducteur (141) et le second conducteur (151) englobe une portion (142, 152) en forme de plaque mince et des portions (143, 144, 153, 154) en forme de plaques épaisses disposées sur les deux côtés de la portion (142, 152) en forme de plaque mince ; et
dans lequel le premier dispositif de conversion magnétoélectrique (102, 112) et le second dispositif de conversion magnétoélectrique (103, 113) sont disposés d'une manière telle que la portion (142) en forme de plaque mince du premier conducteur (101) est intercalée entre eux.

2. Détecteur de courant (1) selon la revendication 1, dans lequel le premier conducteur (141) et le second conducteur (151) possèdent des configurations en forme de plaques dont les directions en largeur sont perpendiculaires au plan (P), et les positions centrales du premier conducteur (141) et du second conducteur (151) dans la direction en largeur sont situées dans le plan (P).

3. Détecteur de courant (1) selon la revendication 1 ou 2, comprenant en outre :
une paire de blindages magnétiques (121, 122, 123) qui traversent le plan (P) et qui sont disposés d'une manière telle que le premier conducteur (141), le premier dispositif de conversion magnétoélectrique (102, 112) et le second dispositif magnétoélectrique (103, 113) sont intercalés entre eux.

4. Détecteur de courant (1) selon l'une quelconque des revendications 1 à 3, dans lequel le premier dispositif de conversion magnétoélectrique (102, 112) et le second dispositif de conversion magnétoélectrique (103, 113) sont disposés d'une manière telle que leurs directions d'axes de sensibilité sont perpendiculaires au plan (P).

5. Détecteur de courant (1) selon l'une quelconque des revendications 1 à 4, dans lequel les conducteurs (141, 151) s'étendent dans une première direction ; dans lequel l'épaisseur des portions (142, 152) en forme de plaques minces, dans une deuxième direction qui est orientée perpendiculairement à la première direction, est inférieure à celle des portions (143, 144, 153, 154) en forme de plaques épaisses dans ladite deuxième direction ; dans lequel la largeur des portions (142, 152) en forme de plaques minces, dans une troisième direction qui est orientée perpendiculairement à la première direction et à la deuxième direction, est identique à celle des portions (143, 144, 153, 154) en forme de plaques épaisses dans ladite troisième direction ; dans lequel des conducteurs (145, 146, 155, 156) sont reliés de manière respective aux portions (143, 144, 153, 154) en forme de plaques épaisses ; et dans lequel chacun des conducteurs (145, 146, 155, 156) possède une configuration analogue à celle d'une plaque plate parallèle à la première direction et à la troisième direction.
